# EUROPÄISCHE PATENTANMELDUNG

(11) **EP 0 597 266 A2**
(43) Veröffentlichungstag der Anmeldung: **18.05.1994**
(21) Anmeldenummer: 93116510.4
(22) Anmeldetag: 12.10.1993
(51) Int. Cl.: H01L 21/76, H01L 21/225

(54) **Verfahren zur Herstellung einer Isolationsstruktur in einem Substrat**

(30) Priorität: 10.11.1992 DE 4237905
(71) Anmelder: SIEMENS AKTIENGESELLSCHAFT, D-80333 München (DE)
(72) Erfinder: Oppermann, Klaus-Günter, D-83607 Holzkirchen (DE)

(57) **Zusammenfassung**

Zur Herstellung einer Isolationsstruktur in einem Substrat wird an der Oberfläche des Substrats ein von einem ersten Leitfähigkeitstyp dotiertes Gebiet (12) erzeugt, das in vertikaler Richtung durch eine Isolation (11, 12) begrenzt ist. In die Oberfläche des vom ersten Leitfähigkeitstyp dotierten Gebietes (12) wird ein Graben (13) geätzt, der ein zu isolierendes Gebiet (121) vollständig umgibt. Durch Ausdiffusion aus von einem zweiten, zum ersten entgegengesetzten Leitfähigkeitstyp dotierten Material (131), das zuvor auf die Oberfläche des Grabens (13) aufgebracht wird, wird ein vom zweiten Leitfähigkeitstyp dotiertes Gebiet (14) erzeugt, das sich in zur Oberfläche des Substrats vertikaler Richtung unterhalb des Grabens (13) bis zu der Isolation (11, 12) erstreckt.

## Beschreibung

In integrierten Schaltungen, die in einem Substrat enthalten sind, müssen vielfach einzelne Bauelemente gegeneinander oder gegenüber dem Substrat elektrisch isoliert werden. Die Bauelemente können dann auf unterschiedlichem Potential betrieben werden. Eine gegenseitige Beeinflussung der Bauelemente erfolgt nicht.

Dazu werden im Substrat Isolationsstrukturen hergestellt, die ein zu isolierendes Gebiet vollständig umgeben. In diesem zu isolierenden Gebiet wird das Bauelement realisiert.

Ein solches zu isolierendes Gebiet wird vielfach als Wanne bezeichnet. Die Tiefe der Wanne, d. h. die Ausdehnung des zu isolierenden Gebietes senkrecht zur Oberfläche des Substrats, wird dabei von den Spannungsanforderungen vorgegeben. Bei einer geforderten Spannungsfestigkeit bis 500 V ist in Silizium eine Wannentiefe von etwa 30 um erforderlich. Soll die Spannungsfestigkeit bis 800 V gegeben sein, ist in Silizium eine Wannentiefe von etwa 50 um erforderlich.

Zur Isolation werden z. B. in Sperrichtung gepolte pn-Übergänge verwendet (siehe z. B. P. Antognetti, Ed., Power Integrated Circuits: Physics, Design and Applications, McGraw Hill; Kap. 5.1.1;). Ein zu isolierendes Gebiet wird dabei vollständig durch einen pn-Übergang umschlossen. Dazu wird unterhalb des zu isolierenden Gebietes z. B. eine vergrabene Schicht erzeugt, die vom entgegengesetzten Leitfähigkeitstyp dotiert ist wie das zu isolierende Gebiet. Zur lateralen Isolation wird eine Tiefdiffusion durchgeführt, die von der Oberfläche des Substrats in die Tiefe reicht. Dabei muß eine hohe Temperaturbelastung des Substrats in Kauf genommen werden. Die Dauer der Temperaturbelastung nimmt mit zunehmender Wannentiefe zu. Ferner tritt bei der Tiefdiffusion gleichzeitig eine laterale Ausdiffusion auf. Dieses fuhrt zu einem großen Flächenbedarf, der mit zunehmender Wannentiefe ebenfalls zunimmt. Dieses Problem kann durch gleichzeitige Diffusion aus einer vergrabenen Schicht und von der Oberfläche des Substrats aus abgemildert werden. Dennoch ist die maximal erreichbare Wannentiefe auf etwa 20 bis 30 um begrenzt. Spannungsanforderungen über 500 V können daher mit dieser Isolationstechnik praktisch nicht erfüllt werden.

Eine Verbesserung der Spannungsfestigkeit in lateraler Richtung kann durch Einsatz des sog. Resurf-Prinzips, das aus J.A. Appels et al., IEDM Techn. Digest (1979), S. 238-241 bekannt ist, erreicht werden. Dabei werden die zur lateralen Isolation eingesetzten Diffusionsgebiete höher dotiert als die zur vertikalen Isolation eingesetzten Gebiete, z. B. die vergrabene Schicht. Dadurch steigt die Spannungsfestigkeit in lateraler Richtung und in vertikaler Richtung. Für viele Schaltungsanwendungen ist das Resurf-Prinzip jedoch nicht verwendbar. Z. B. sind High-Side-Schalter nur für stark reduzierte Sperrfähigkeit möglich. Ferner ist die Anwendbarkeit des Resurf-Prinzips begrenzt auf Schaltungsanordnungen, in denen in dem zu isolierenden Gebiet eine relativ geringe Dotierung vorherrscht. Sobald das isolierende Gebiet hochdotierte Bereiche, wie z. B. eine vergrabene Schicht, umfaßt, kann das Resurf-Prinzip nicht angewendet werden.

Als weitere Isolationstechnik ist bekannt (siehe z. B. N. Yasuhara et al., IEDM Techn. Digest (1991), S. 141-144)), ein zu isolierendes Gebiet vollständig mit einer dielektrischen Schicht zu umgeben. Dabei wird das zu isolierende Gebiet z. B. in vertikaler Richtung durch eine durchgehende Si0₂-Schicht isoliert. Die laterale Isolation wird durch einen mit Si0₂ und Poly-Silizium aufgefüllten, geätzten Graben, der das zu isolierende Gebiet vollständig umgibt, realisiert. Bekannte Ätzverfahren zur Herstellung des Grabens erlauben die Herstellung von Gräben mit einer Tiefe bis zu 20 um. Da der Graben mit der isolierenden Schicht zur vertikalen Isolation in Verbindung stehen muß, begrenzt die Grabentiefe von 20 um die erzielbare Wannentiefe. Sie begrenzt dadurch die maximale Bauelementspannung auf unter 500 V.

Eine weitere Möglichkeit besteht in einer klassischen dielektrischen Isolation mit Siliziumwannen auf einem Poly-Silizium Substrat. Dabei sind im Prinzip keine Begrenzungen der Wannentiefe gegeben, das Verfahren ist jedoch mit der gängigen IC-Technologie nicht verträglich.

Der Erfindung liegt das Problem zugrunde, ein Verfahren zur Herstellung einer Isolationsstruktur in einem Substrat anzugeben, mit dem größere Wannentiefen von zu isolierenden Gebieten und damit Durchbruchfestigkeiten bis zu höheren Spannungen erzielt werden können.

Dieses Problem wird erfindungsgemäß gelöst durch ein Verfahren nach Anspruch 1. Dabei wird das zu isolierende Gebiet in vertikaler Richtung durch eine Isolation begrenzt, die sowohl eine dielektrische Schicht als auch ein pn-Übergang sein kann.

Zur lateralen Isolation umfaßt die Isolationsstruktur einen Graben, der das zu isolierende Gebiet vollständig umgibt. In dem Graben wird auf die Oberfläche des Grabens ein Material aufgebracht, das vom entgegengesetzten Leitfähigkeitstyp dotiert ist wie das zu isolierende Gebiet. Durch Ausdiffusion aus dem dotierten Material wird an den Graben angrenzend ein dotiertes Gebiet erzeugt, das einen pn-Übergang bewirkt. Das dotierte Gebiet erstreckt sich in vertikaler Richtung unterhalb des Grabens bis zu der Isolation. Die erreichbare Wannendicke ist gegeben durch die Tiefe des Grabens und die Tiefe der Ausdiffusion unterhalb des Grabens. Damit können Wannendicken erreicht werden, die deutlich größer sind als die maximal erreichbare Grabentiefe.

Es liegt im Rahmen der Erfindung, den Graben mit dotiertem Poly-Silizium aufzufüllen und das dotierte Poly-Silizium als Diffusionsquelle für die Ausdiffusion zu verwenden. Das dotierte Poly-Silizium kann ebenfalls als Kontakt für eine unterhalb des Grabens angeordnete vergrabene Schicht dienen.

Gemäß einer anderen Ausführungsform der Erfindung wird als dotiertes Material dotiertes Glas verwendet. Dabei ist sowohl Borglas als auch Phosphorglas geeignet. Nach der Ausdiffusion kann das dotierte Glas im Graben verbleiben. Der Graben kann dann mit dotiertem Poly-Silizium oder mit Si0₂ und dotiertem Poly-Silizium aufgefüllt werden.

Alternativ wird das dotierte Glas entfernt.

Der Graben wird dann z. B. mit Si0₂ aufgefüllt. Eine andere Möglichkeit besteht darin, an der Wand des Grabens Si0₂ abzuscheiden und den Graben mit Poly-Silizium aufzufüllen.

Es ist vorteilhaft, mindestens die Wand des Grabens mit einer Si0₂ Schicht zu versehen, da dadurch die pn-Übergangsfläche reduziert wird, über die eine Kopplung benachbarter Wannen möglich ist.

Weitere Ausgestaltungen der Erfindung gehen aus den übrigen Ansprüchen hervor.

Im folgenden wird die Erfindung anhand eines Ausführungsbeispiels und der Figuren näher erläutert.
Figur 1 zeigt einen Ausschnitt aus einem Substrat mit einem pn-Übergang als vertikale Isolation.
Figur 2 zeigt einen Ausschnitt aus einem Substrat mit einer dielektrischen Schicht als vertikale Isolierung.

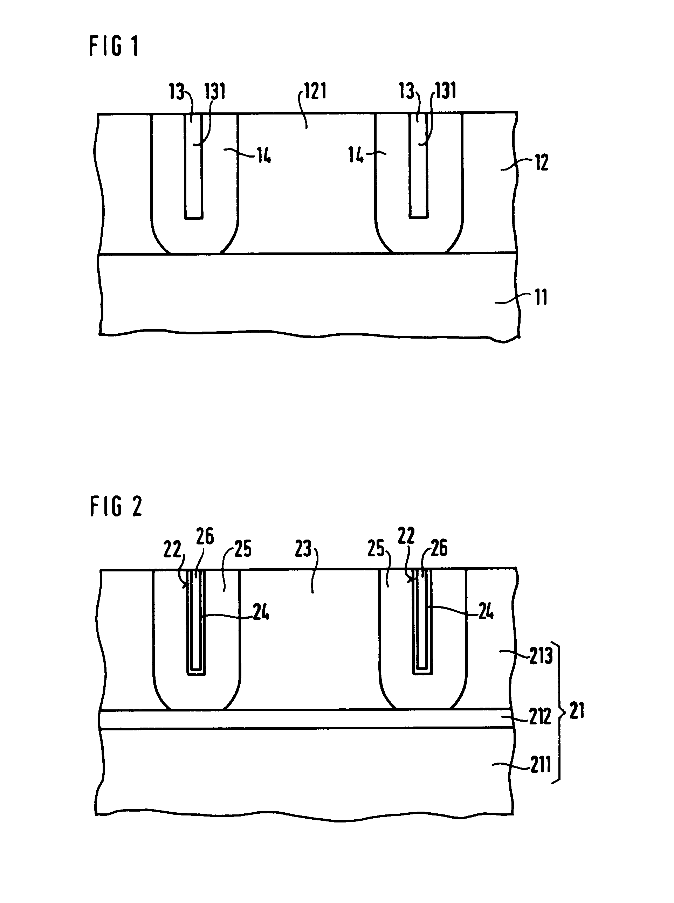

Auf ein Substrat, das z. B. aus einer einkristallinen Siliziumscheibe und einer vergrabenen Schicht 11 besteht, die mindestens im Bereich der Oberfläche mit einer Dotierstoffkonzentration von 10¹⁸ cm-³ p-dotiert ist, wird z. B. durch Epitaxie eine n-dotierte Siliziumschicht 12 aufgebracht (s. Figur 1). In die Oberfläche der Siliziumschicht 12 wird ein Graben 13 geätzt, der ein zu isolierendes Gebiet 121 vollständig umgibt.

Der Graben 13 wird mit dotiertem Material 131 aufgefüllt. Das dotierte Material 131 ist z. B. p⁺⁻ dotiertes Poly-Silizium. Die Dotierstoffkonzentration im dotierten Material 131 wird möglichst hoch eingestellt.

Durch Ausdiffusion bei z. B. 1100 _{°} C wird den Graben 13 umgebend ein dotiertes Gebiet 14 erzeugt. Unterhalb des Grabens 13 erstreckt sich das dotierte Gebiet 14 bis zur Oberfläche der vergrabenen Schicht 11. In dem dotierten Gebiet 14 stellt sich an der Grenzfläche zum Graben 13 eine Dotierstoffkonzentration von z. B. 10¹⁸ cm-³ ein. Der aus dem zu isolierenden Gebiet 121, das n-dotiert ist, und dem dotierten Gebiet 14, das p-dotiert ist, gebildete pn-Übergang bewirkt die laterale Isolation des zu isolierenden Gebietes 121 zur Umgebung. In vertikaler Richtung bewirkt der aus der vergrabenen Schicht 11, die p-dotiert ist, und dem zu isolierenden Gebiet 121, das n-dotiert ist, gebildete pn-Übergang die Isolation.

Wird als dotiertes Material 131 dotiertes Poly-Silizium verwendet, so verbleibt dieses nach Fertigstellung des dotierten Gebietes 14 in dem Graben 13. Das dotierte Poly-Silizium kann gleichzeitig als Anschluß zu der vergrabenen Schicht 11 verwendet werden.

Alternativ kann als dotiertes Material 131 dotiertes Glas, das Bor-dotiert ist, verwendet werden. Nach der Herstellung des dotierten Gebietes 14 durch Ausdiffusion kann das dotierte Glas abgeätzt werden und der Graben 13 mit Si0₂ aufgefüllt werden.

Der Graben 13 wird in eine Tiefe von z. B. 20 um geätzt. Der Abstand zwischen dem Graben 13 und der vergrabenen Schicht 11 beträgt z. B. 10 um. Damit beträgt die Wannentiefe des zu isolierenden Gebietes 121 etwa 30 um.

In einem zweiten Ausführungsbeispiel wird ein Substrat 21 verwendet, das eine Siliziumscheibe 211, eine darauf angeordnete dielektrische Schicht 212 und ein darauf angeordnetes n-dotiertes Siliziumgebiet 213 umfaßt (s. Fig. 2). Die dielektrische Schicht 212 besteht z. B. aus Si0₂ und weist eine Dicke von z. B. 2 um auf. In die Oberfläche des n-dotierten Gebietes 213 wird ein Graben 22 geätzt. Der Graben 22 umgibt ein zu isolierendes Gebiet 23 vollständig.

In den Graben 22 wird dotiertes Material 24 eingebracht, das die Oberfläche des Grabens 22 vollständig bedeckt. Das dotierte Material 24 ist z. B. mit Bor dotiertes Glas.

Durch Ausdiffusion aus dem dotierten Material 24 wird an den Graben 22 angrenzend ein p-dotiertes Gebiet 25 erzeugt. Das p-dotierte Gebiet 25 reicht unterhalb des Grabens 22 bis zu der dielektrischen Schicht 212.

In dem dotierten Material 24 wird die Dotierstoffkonzentration möglichst hoch, nahe dem Sättigungswert eingestellt. Dadurch stellt sich in dem p-dotierten Gebiet 25 eine Dotierstoffkonzentration an der Grenzfläche zum Graben von z. B. 10¹⁹ cm-³ ein.

Nach der Herstellung des p-dotierten Gebietes 25 wird der Graben z. B. mit Poly-Silizium 26 aufgefüllt. Vor der Auffüllung mit dem Poly-Silizium 26, das dotiert oder undotiert sein kann, kann an der Oberfläche des dotierten Glases 24 zusätzlich eine Si0₂-Schicht abgeschieden werden.

Alternativ dazu kann das dotierte Glas nach der Herstellung des p-dotierten Gebietes 25 abgeätzt werden. Der Graben 22 wird in diesem Fall mit Si0₂ aufgefüllt.

Der Graben 22 wird in einer Tiefe von z. B. 20 um hergestellt. Die erzielte Wannentiefe betragt etwa 30 um, da sie aus der Tiefe des Grabens und der Ausdehnung des p-dotierten Gebietes 25 zusammengesetzt ist. Die Breite der lateralen Isolationsstruktur setzt sich zusammen aus der Ausdehnung des p-dotierten Gebietes 25 und des Grabens 22. Sie ist erheblich geringer als die Wannentiefe.

In vertikaler Richtung ist das zu isolierende Gebiet 23 durch die dielektrische Schicht 212 isoliert. In horizontaler Richtung ist das zu isolierende Gebiet 23 durch den pn-Übergang, der aus dem zu isolierenden Gebiet 23 und den p-dotierten Gebiet 25 gebildet wird, isoliert.

## Patentansprüche

1. Verfahren zur Herstellung einer Isolationsstruktur in einem Substrat,
- bei dem an der Oberfläche des Substrats ein von einem ersten Leitfähigkeitstyp dotiertes Gebiet (12, 213) erzeugt wird, das in zur Oberfläche vertikaler Richtung durch eine Isolation (11, 12; 212) begrenzt ist,
- bei dem in die Oberfläche des vom ersten Leitfähigkeitstyp dotierten Gebietes (12, 213) ein Graben (13, 22) geätzt wird, der ein zu isolierendes Gebiet (121, 23) vollständig umgibt,
- bei dem auf die Oberfläche des Grabens (13, 22) ein von einem zweiten, zum ersten entgegengesetzten Leitfähigkeitstyp dotiertes Material (131, 24) aufgebracht wird,
- bei dem durch Ausdiffusion aus dem dotierten Material (131, 24) in dem vom ersten Leitfähigkeitstyp dotierten Gebiet ein vom zweiten Leitfähigkeitstyp dotiertes Gebiet (14, 25) erzeugt wird, das sich in zur Oberfläche des Substrats vertikaler Richtung unterhalb des Grabens (13, 22) bis zu der Isolation (11, 12; 212) erstreckt.

2. Verfahren nach Anspruch 1, bei dem als dotiertes Material (131, 24) dotiertes Poly-Silizium verwendet wird, mit dem der Graben vor der Ausdiffusion aufgefüllt wird.

3. Verfahren nach Anspruch 1, bei dem als dotiertes Material (24) dotiertes Glas verwendet wird, das auf die Oberfläche des Grabens (22) aufgebracht wird.

4. Verfahren nach Anspruch 3, bei dem nach der Ausdiffusion der Graben (22) mit dotiertem Poly-Silizium (26) aufgefüllt wird.

5. Verfahren nach Anspruch 4, bei dem nach der Ausdiffusion und vor der Auffüllung des Grabens im Graben (22) Si0₂ abgschieden wird.

6. Verfahren nach Anspruch 3, bei dem nach der Ausdiffusion das dotierte Glas abgeätzt wird und der Graben mit Si0₂ aufgefüllt wird.

7. Verfahren nach Anspruch 3, bei dem nach der Ausdiffusion das dotierte Glas abgeätzt wird, bei dem an der Grabenoberfläche Si0₂ aufgebracht wird und bei dem der Graben mit Poly-Silizium aufgefüllt wird.

8. Verfahren nach einem der Ansprüche 1-7, bei dem die Isolation in vertikaler Richtung durch einen pn-Übergang (11, 12) realisiert wird.

9. Verfahren nach einem der Ansprüche 1-7, bei dem die Isolation in vertikaler Richtung durch eine dielektrische Schicht (212) realisiert wird.

10. Verfahren nach einem der Ansprüche 1 bis 9, bei dem das vom ersten Leitfähigkeitstyp dotierte Gebiet (12, 213) aus einkristallinem Silizium besteht.
